# EUROPEAN PATENT SPECIFICATION

(11) **EP 1 970 389 B1**
(45) Date of publication and mention of the grant of the patent: **19.02.2014**
(21) Application number: 06833759.1
(22) Date of filing: 30.11.2006
(51) Int. Cl.: C08G 14/09, C08G 59/62, C08J 5/24, C08L 61/34

(54) **PHENOL RESIN COMPOSITION, CURED PRODUCT THEREOF, RESIN COMPOSITION FOR COPPER CLAD LAMINATE, COPPER CLAD LAMINATE AND NOVEL PHENOL RESIN**
PHENOLHARZZUSAMMENSETZUNG, GEHÄRTETES PRODUKT DAVON, HARZZUSAMMENSETZUNG FÜR KUPFERUMMANTELTES LAMINAT, KUPFERUMMANTELTES LAMINAT UND NEUES PHENOLHARZ
COMPOSITION DE RESINE PHENOLIQUE, PRODUIT DURCI A PARTIR DE CELLE-CI, COMPOSITION DE RESINE POUR STRATIFIE PLAQUE CUIVRE, STRATIFIE PLAQUE CUIVRE ET NOUVELLE RESINE PHENOLIQUE

(30) Priority: 30.11.2005 JP 2005345631
(43) Date of publication of application: 17.09.2008
(73) Proprietor: DIC Corporation, Tokyo 174-8520 (JP)
(72) Inventor: IMADA, Tomoyuki, Ichihara-shi, Chiba 290-8585 (JP); YOSHIZAWA, Masakazu, Ichihara-shi, Chiba 290-8585 (JP)
(74) Representative: Albrecht, Thomas
(86) International application number: PCT/JP2006/323956
(87) International publication number: WO 2007/063947

(56) References cited:
- JP-A- 8 176 249
- JP-A- 9 208 821
- JP-A- 08 176 249
- JP-A- 09 208 821
- JP-A- 10 152 547
- JP-A- 10 152 547
- JP-A- 2000 309 679
- JP-A- 2000 309 679

## Description

### TECHNICAL FIELD

The present invention relates to a phenol resin composition which has excellent heat resistance and flame retardancy in a cured article and is suitable for use as a resin composition for a printed circuit board, the cured article, a resin composition for a printed circuit board, a copper-clad laminate having both excellent heat resistance and flame retardancy, and a novel phenol resin which imparts these performances to the cured article.

### BACKGROUND ART

A curable composition comprising a phenol resin and an epoxy resin as essential components gives a cured article having excellent heat resistance, adhesion and electrical insulation properties and is therefore preferably used in applications such as semiconductor encapsulating materials, printed circuit boards, coating materials and casting materials. In technical fields such as electric components and electronic components of these applications, resin materials need flame retardancy. For example, resin materials used as semiconductor encapsulating materials are mixed with halogen-based flame retardants such as brominated epoxy resins and flame-retardant auxiliaries such as antimony compounds (e.g. antimony trioxide, antimony tetraoxide and antimony pentaoxide, etc.) so as to impart flame retardancy. However, as the action on the environment and safety is recently being promoted, use of halogen-based flame retardants with a problem such as generation of dioxin and antimony compounds with a problem of carcinogenicity tends to be avoided. Therefore, development of a novel flame retardation method with less of environmental burden instead of the above-mentioned methods is strongly required.

With recent technical innovations, a thermocurable resin composition having all of heat resistance, moisture resistance, flame retardancy, a low dielectric constant, a low dielectric dissipation factor and low thermal expansion in high levels is required. Therefore, a phenol resin used in combination with an epoxy resin also need to have performances with high added value such as heat resistance, moisture resistance, flame retardancy and a low dielectric constant, and development of the material which is halogen-free and has high flame retardancy is strongly required, especially.

To solve the problems described above, technologies are proposed in which a novolak type phenol resin containing a triazine ring in the molecular structure is used as a curing agent of the epoxy resin in a thermocuring system which is halogen-free and exhibits excellent flame retardancy (see, for example, Patent Documents 1 and 2 below).

However, although the novolak type phenol resin containing a triazine ring in the molecular structure exhibits high-level flame retardancy in a cured article thereof, it was difficult to obtain a cured article having excellent heat resistance because that the novolak type phenol resin is originally inferior in heat resistance, since the flame retardancy of the phenol resin is due to generation of an inert gas by the decomposion of the molecular structure upon combustion,.

### [Patent Document 1]

Japanese Patent No. 3,502,042

### [Patent Document 2]

Japanese Unexamined Patent Application, First Publication No. 2001-226464

JP 9 208821 A relates to a composition for water-base coating material and water-base coating material. This composition is obtained by compounding a specific amino resin with a water-base resin having groups reactive therewith. It contains 10-80 parts by weight amino resin and 20-90 parts by weight water-base resin having groups reactive therewith. The amino resin is obtained by condensing 2-, 3-, or 4-(4,6-diamino-1,3,5-triazin-2-yl)benzoic acid with an aldehyde compound and simultaneously etherifying with a monohydric alcohol compound. The water-base resin is preferably a hydroxylated carboxylic acid resin having both hydroxyl and carboxyl groups and having an acid value of about 10-200 and a hydroxyl value of about 5-250.

JP 8 176249 A relates to an alkyl-etherified amino resin. It is obtained by subjecting a specific compound to methylolation and then to alkyl-etherification. In particular, 2-(4,6-Diamino-1,3,5-triazin-2-yl)benzoic acid is methylolated with formaldehyde and then alkyl-etherified with a 1-6C alcohol, giving an alkyl-etherified amino resin having a weight-average molecular weight (by gel permeation chromatography) of 350-50,000.

JP 10 152547 A relates to a resin composition for sealing semiconductors. This composition comprises (A) an epoxy resin, (B) a phenol resin curing agent containing 30-100 wt.% of a benzoguanamine modified phenol resin, (C) a curing promoter, (D) a metal hydroxide and (E) an inorganic filler. Preferably, the component D is aluminum hydroxide or magnesium hydroxide, has 5-50 µm average particle diameter and ≤ 102 µm maximum particle diameter, the amount of the component D is 3.0-30.0 wt.% and that of the component E is 60-90 wt.%.

JP 2000 309679 A relates to an epoxy resin forming material for sealing. This epoxy resin forming material is obtained by incorporating (A) an epoxy resin having ≥ 2 epoxy groups in 1 molecule, (B) a curing agent containing a polycondensate of a compound having phenolic hydroxyl group, 300-1,500 number-average molecular weight and 650-10,000 weight-average molecular weight (e.g. phenol) with a triazine derivative (preferably melamine) and a compound having aldehyde group (e.g. formalin), (C) a curing accelerator (e.g. an adduct of triphenyl phosphine with p-benzoquinone) and (D) an inorganic filler as essential components.

### DISCLOSURE OF THE INVENTION

Thus, an object to be achieved by the present invention is to provide a phenol resin composition which imparts both excellent heat resistance and flame retardancy in a cured article, the cured article, a resin composition for a copper-clad laminate, and a copper-clad laminate having both excellent heat resistance and flame retardancy.

The present inventors have intensively studied so as to achieve the above object and found that, by using a condensation compound which is obtained by reacting a triazine compound having both a carboxyl group-containing aromatic hydrocarbon group and an amino group on a triazine ring with aldehydes and phenols, as a main component of a thermocurable resin composition, the resulting cured article not only exhibits excellent flame retardancy but also has heat resistance as a performance which is originally incompatible with flame retardancy, in the meantime. Thus, the present invention has been completed.

Namely, the present invention relates to a phenol resin composition comprising a phenol resin (I) having a chemical structure (A) in which an aromatic hydrocarbon group substituted with a carboxyl group is bonded to a triazine ring (a chemical structure (A) in which a carboxyl group is bonded to a triazine ring via a divalent aromatic hydrocarbon group), as a partial structure in the molecular structure, and a curing agent (II) as essential components.

The present invention also relates to a resin composition for a copper-clad laminate comprising the above phenol resin composition and an organic solvent as essential components.

The present invention also relates to a copper-clad laminate which is obtained by a process comprising the steps of impregnating a glass cloth with the above resin composition for a copper-clad laminate to obtain a prepreg, laminating a plurality of prepregs and copper foils, and curing.

The present invention also relates to a novel phenol resin which has a molecular structure obtained by reacting phenols (x1), a triazine compound (x2) having a carboxyl group-containing aromatic hydrocarbon group and an amino group as substituents on a triazine ring, and aldehydes (x3), and also has a structure represented by structural formula (1) shown below: 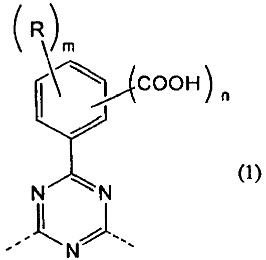 wherein R represents a hydrogen atom, an aliphatic hydrocarbon group having 1 to 4 carbon atoms, an aromatic hydrocarbon group, a bromine atom, or a chlorine atom, the broken line portion represents a bond with the other molecular structure, and n and m represent integers of 1 to 4, in the molecular structure, wherein an ICI melt viscosity of the phenol resin at 150°C is 100 poise or less.

According to the present invention, a phenol resin composition which imparts excellent heat resistance and flame retardancy to a cured article, the cured article, a novel phenol resin, a resin composition for a copper-clad laminate, and a copper-clad laminate having both excellent heat resistance and flame retardancy can be provided.

Therefore, especially in the application of resin compositions for a copper-clad laminate, the phenol resin composition of the present invention is particularly useful as materials with a high performance in high density mounting, high frequency and high speed calculation. Also, a cured article obtained by thermocuring the composition exhibits not only flame retardancy and heat resistance but also good characteristics such as moisture resistance and adhesion. Therefore, it is useful not only in electrical and electronic components, but also in applications such as adhesives and composite materials.

### BRIEF DESCRIPTION OF THE DRAWINGS

Fig. 1 is a GPC chart of a phenol resin (A-1) obtained in Example 1.
Fig. 2 is a GPC chart of a phenol resin (A-2) obtained in Example 2.
Fig. 3 is a GPC chart of a phenol resin (A-3) obtained in Example 3.
Fig. 4 is a GPC chart of a phenol resin (A'-1) obtained in Comparative

### Example 1.

### BEST MODE FOR CARRYING OUT THE INVENTION

As described above, the phenol resin composition of the present invention comprises a phenol resin (I) having a chemical structure (A) in which an aromatic hydrocarbon group substituted with a carboxyl group is bonded to a triazine ring (a chemical structure (A) in which a carboxyl group is bonded to a triazine ring via a divalent aromatic hydrocarbon group), as a partial structure in the molecular structure, and a curing agent (II) as essential components. In the present invention, since the phenol resin composition has a triazine skeleton in the molecular structure of the phenol resin (I), when the cured article is exposed to an environment at a high temperature close to 300°C at which combustion arises, the triazine skeleton is decomposed and an inert nitrogen gas is emitted to form a layer of the inert gas on the surface of the molded article, and thus excellent flame retardancy is exhibited. When the phenol resin (I) is cured, the carboxyl group in the resin is bonded to the curing agent (II), thereby suppressing excess decomposition of the triazine skeleton under the environment at high temperature. As a result, the phenol resin (I) having a carboxyl group-containing triazine skeleton (A) in the molecular structure becomes a material having both heat resistance and flame retardancy in a good balance.

Herein, the chemical structure (A) in which an aromatic hydrocarbon group substituted with a carboxyl group is bonded to a triazine ring, existing in the phenol resin (I), is a partial chemical structure having a structure in which a carboxyl group is bonded to a triazine ring via a divalent aromatic hydrocarbon group. Herein, the divalent aromatic hydrocarbon group includes a phenylene group, a naphthylene group, a biphenylene group, and a group having a structure in which an alkyl group having 1 to 4 carbon atoms is bonded to such an aromatic nucleus. Specifically, such a chemical structure (A) is preferably represented by structural formula shown below (1) in the present invention since a remarkable effect of improving heat resistance of the cured article is exerted.

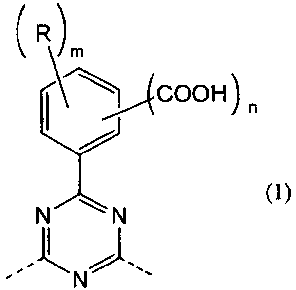

In the formula, R represents a hydrogen atom; an aliphatic hydrocarbon group having 1 to 4 carbon atoms, such as a methyl group, an ethyl group, a propyl group, an i-propyl group, or a t-butyl group; an aromatic hydrocarbon group such as a phenyl group, a naphthyl group, or a biphenyl group; a bromine atom; or a chlorine atom. The broken line portion represents a bond connected with the other molecular structure, and n and m represent integers of 1 to 4.

A triazine structure having a benzoic acid structure represented by the structural formula shown below among the structural formula (1) is preferable since it has the effect of improving heat resistance.

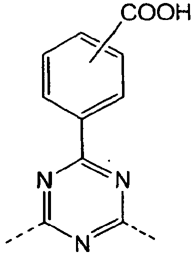

Specifically, the phenol resin (I) having the carboxyl group-containing triazine skeleton (A) in the molecular structure is preferably a molecular structure obtained by reacting phenols (x1), a triazine compound (x2) having a carboxyl group-containing aromatic hydrocarbon group and an amino group as substituents on a triazine ring, and aldehydes (x3) since curability and flame retardancy of the cured article are improved.

Examples of the phenols (x1) used herein include monohydric phenols, for example, phenols such as phenol, o-cresol, m-cresol, p-cresol, o-ethylphenol, methylphenol, p-ethylphenol, o-isopropylphenol, m-propylphenol, p-propylphenol, p-sec-butylphenol, p-tert-butylphenol, p-cyclohexylphenol, p-chlorophenol, o-bromophenol, m-bromophenol, and p-bromophenol, naphthols such as α-naphthol and β-naphthol, and xylenols such as 2,4-xylenol, 2,5-xylenol, and 2,6-xylenol; dihydric phenols, for example, naphthalenediols such as resorcin, catechol, hydroquinone, 2,2-bis(4'-hydroxyphenyl)propane, 1,1'-bis(dihydroxyphenyl)methane, 1,1'-bis(dihydroxynaphthyl)methane, tetramethylbiphenol, biphenol, hexamethylbiphenol, 1,2-dihydroxynaphthalene, 1,3-dihydroxynaphthalene, 1,4-dihydroxynaphthalene, 1,5-dihydroxynaphthalene, 1,6-dihydroxynaphthalene, 1,7-dihydroxynaphthalene, 1,8-dihydroxynaphthalene, 2,3-dihydroxynaphthalene, 2,6-dihydroxynaphthalene, and 2,7-dihydroxynaphthalene; and trihydric phenols such as trishydroxyphenylmethane.

Of these phenols, phenol, o-cresol, m-cresol, naphthols, 2,2-bis(4'-hydroxyphenyl)propane, 2,6-xylenol, resorcin, hydroquinone, 1,5-dihydroxynaphthalene, 1,6-dihydroxynaphthalene, and 2,7-dihydroxynaphthalene are preferable since they are industrially produced with ease and also give a phenol resin (I) excellent in curability, and phenol and o-cresol are particularly preferable.

The triazine compound (x2) having a carboxyl group-containing aromatic hydrocarbon group and an amino group as substituents on a triazine ring include, for example, carboxylnaphthyl-1,3,5-triazine-2,4-diamine; carboxylbiphenyl-1,3,5-triazine-2,4-diamine; and a compound represented by structural formula (2) shown below:

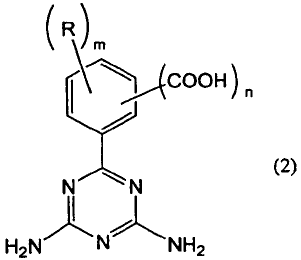

wherein R represents any one of a hydrogen atom, an aliphatic hydrocarbon group, an aromatic hydrocarbon group, and a halogen atom, and n and m represent integers of 1 to 4.

Of these compounds, a compound represented by the above structural formula (2) is particularly preferable since a remarkable effect of improving heat resistance of the cured article is exerted.

Examples of the aldehydes (x3) include aliphatic aldehydes such as formaldehyde, paraformaldehyde, acetaldehyde, and crotonaldehyde; aromatic aldehydes such as benzaldehyde, 4-methylbenzaldehyde, 3,4-dimethylbenzaldehyde, biphenylaldehyde, and naphthylaldehyde; and hydroxyl group-substituted aromatic aldehydes such as salicylaldehyde, 3-hydroxybenzaldehyde, 4-hydroxybenzaldehyde, 2-hydroxy-4-methylbenzaldehyde, 2-hydroxy-3,4-dimethylbenzaldehyde, 4-hydroxybiphenylaldehyde, 2-hydroxy-1-naphthaldehyde, 5-hydroxy-1-naphthaldehyde, 6-hydroxy-1-naphthaldehyde, and 7-hydroxy-2-naphthaldehyde. Of these aldehydes, from the viewpoint of particularly excellent industrial supply stability, and heat resistance, flame retardancy and dielectric characteristics of the resulting cured article, formaldehyde, paraformaldehyde, benzaldehyde, and salicylaldehyde are preferable, and formaldehyde and paraformaldehyde are particularly preferable.

The above phenol resin (I) may have a structure obtained by reacting the phenols (x1), the compound (x2) having a carboxyl group, an amino group and a triazine skeleton, and the aldehydes (x3) with a compound (x4) having another amino group-containing triazine skeleton except for the compound (x2). By using the compound (x4), it becomes easy to adjust the balance between flame retardancy and heat resistance of the cured article.

Examples of the compound (x4) having the triazine ring include, but are not limited to, compounds represented by the structural formula (3) shown below:

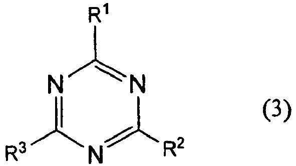

wherein R¹, R², and R³ represent any of an amino group, an alkyl group having 1 to 6 carbon atoms, a phenyl group, a hydroxy group, a hydroxyalkyl group having 1 to 6 carbon atoms, an alkoxy group having 1 to 6 carbon atoms, an alkylcarbonyloxy group having 1 to 6 carbon atoms, an alkyloxycarbonyl group having 1 to 6 carbon atoms, an acid group, a vinyl group, a cyano group, and a halogen atom.

Specific examples of the compound represented by structural formula (3) include melamine; guanamine derivatives such as acetoguanamine and benzoguanamine, cyanuric acid, and cyanuric acid derivatives such as methylcyanurate, ethylcyanurate, acetyl cyanurate and cyanuric chloride. Of these compounds, guanamine derivatives in which one, two or three substituents of R₁, R₂ and R₃ are amino groups, such as melamine, acetoguanamine and benzoguanamine are more preferable due to their easy industrially available.

The phenol resin (I) used in the present invention is obtained by reacting the respective components (x1) to (x3) or reacting the respective components (x1) to (x4). Specific examples thereof include those having a structure a or b shown below: 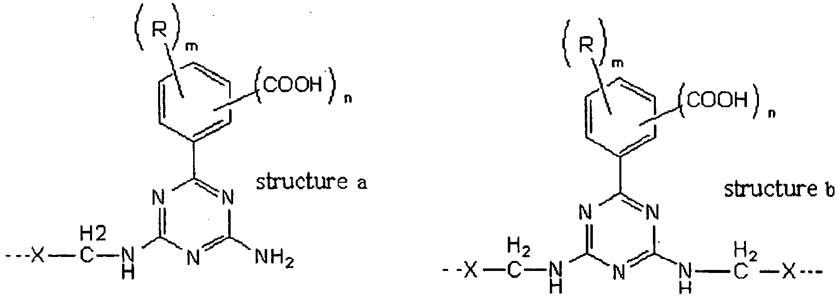 in the molecular structure of the phenol novolak resin. Herein, R, m and n are as defined in structural formula (1), and X represents an aromatic core in the phenol novolak resin. It is also possible to have a structure in which a plurality of triazine structures are linked as shown in the following structure c in the molecular structure of the phenol resin (I).

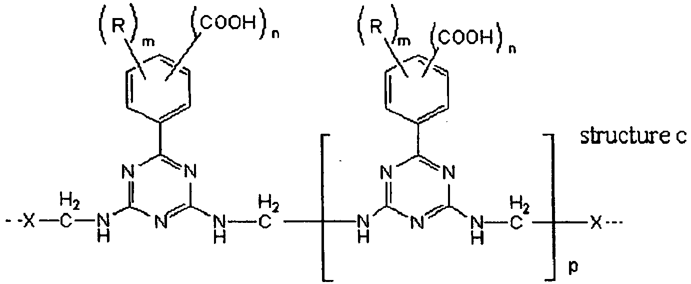

In the structure c, R, m, n, and X are as defined in the structure a or b, and p represents an integer of 1 to 5.

In the present invention, the content of the unreacted phenols (x1) remaining in the phenol resin (I) is preferably 3% by mass or less. When the content of the unreacted phenols (x1) is 3% by mass or less, the cured article obtained by curing has excellent heat resistance and moisture resistance.

Next, the method of reacting the above respective components (x1) to (x3) or respective components (x1) to (x4) to produce a phenol resin (I) includes, for example, a method of reacting phenols (x1), a compound (x2), aldehydes (x3) and, if necessary, the compound (x4) in the absence or presence of a catalyst. In this case, the pH of the system is preferably within a range of 3.0 to 9.0. There is no limitation on the order of the reaction of the respective raw materials. The compound (x2) and, if necessary, the compound (x4) may be added after the phenols (x1) and the aldehydes (x3) are reacted first. In reverse, the phenols (x1) may be added and reacted after the aldehydes (x3), the compound (x2) and, if necessary, the compound (x4) are reacted. Alternatively, all raw materials may be simultaneously added and reacted.

At this time, there is no limitation on the molar ratio of the aldehydes (x3) to the phenols (x1). The molar ratio of aldehydes (x3) to phenols (x1) is preferably from 0.1 to 1.1 ((x3)/(x1)), and more preferably from 0.2 to 0.8.

The molar ratio of the compound (x2) to the phenols (x1) (compound (x2)/phenols (x1)) is preferably from 0.05 to 1.50, and particularly preferably from 0.05 to 0.50, from the viewpoint that the reaction system is uniform and the reaction product is also uniform, and also the resulting cured article has proper crosslinking density and has excellent physical properties.

When the compound (x4) is used, the molar ratio of the total of the compound (x2) and the compound (x4) to the phenols (x1) (total of the compound (x2) and the compound (x4)) /phenols (x1)) is preferably from 0.05 to 1.50, and particularly preferably from 0.05 to 0.50, the molar ratio of the compound (x2) to the compound

(x4) (compound (x2)/compound (x4)) being from 0.05 to 9.00 from the viewpoint that the reaction system is uniform and the reaction product is also uniform, and the resulting cured article also has proper crosslinking density and has excellent balance between flame retardancy and heat resistance. When heat resistance is regarded as important from the viewpoint of the balance between the physical properties, the molar ratio of the compound (x2) to the compound (x4) (compound (x2)/compound (x4)) is preferably from 0.5 to 7.0. When solvent solubility is regarded as important, the molar ratio of the compound (x2) to the compound (x4) (compound (x2)/compound (x4)) is preferably from 0.1 to 3.0. Therefore, the molar ratio of the compound (x2) to the compound (x4) (compound (x2)/compound (x4)) is preferably within a range of 0.5 to 3.0, which overlaps the above ranges, from the viewpoint that a phenol resin (I) having good balance between heat resistance and solvent solubility can be obtained.

When a catalyst is used, examples of a basic catalyst include hydroxides of alkali and alkali earth metals, such as sodium hydroxide, potassium hydroxide and barium hydroxide, and oxides thereof; ammonia; primary to tertiary amines; hexamethylenetetramine; and sodium carbonate. Examples of an acid catalyst include inorganic acids such as hydrochloric acid, sulfuric acid, sulfonic acid, and phosphoric acid; organic acids such as oxalic acid and acetic acid; Lewis acids; and divalent metal salts such as zinc acetate. When the phenol resin composition of the present invention is used as a resin for electric or electronic materials, it is preferable that inorganic substances such as metal do not remain as a catalyst residue. Therefore, it is preferable that amines are used as the basic catalyst and organic acids are used as the acidic catalyst. From such a point of view, it is particularly preferable in the present invention that the reaction is carried out in the absence of the catalyst.

The reaction may be carried out in the presence of various solvents from the viewpoint of control of the reaction. If necessary, impurities such as salts may be removed by neutralization and washing with water. When the reaction is carried out in the absence of a catalyst or using amines as the catalyst, it is not necessary to remove impurities.

After the completion of the reaction, condensation water, the unreacted aldehydes (x3), phenols (x1) and solvents are removed by a conventional method such as normal pressure distillation or vacuum distillation. At this time, a heat treatment is preferably carried out at 120°C or higher so as to obtain a phenol resin (I) which substantially has no methylol group. The methylol group can be eliminated by subjection to a heat treatment for a sufficient time at a temperature of 120°C or higher. It is preferable to carry out the heat treatment at a higher temperature, preferably 150°C or higher, so as to efficiently eliminate the methylol group. In this heat treatment, it is preferable to distill with heating in accordance with a conventional method used to obtain a novolak resin.

The phenol resin (I) thus obtained is preferably a novel phenol resin of the present invention, which is characterized in that the ICI melt viscosity at 150°C is 100 poise or less from the viewpoint of excellent balance between flame retardancy and heat resistance. Therefore, it is preferably a novel phenol resin of the present invention, which has a structural site represented by the structural formula shown below (I): 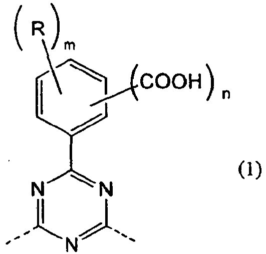 wherein R represents a hydrogen atom, an aliphatic hydrocarbon group having 1 to 4 carbon atoms, an aromatic hydrocarbon group, a bromine atom, or a chlorine atom, the broken line portion represents a bond with the other molecular structure, and n and m represent integers of 1 to 4, in the molecular structure, wherein an ICI melt viscosity of the phenol resin at 150°C is 100 poise or less.

Also, the melt viscosity of the phenol resin (I) is particularly preferably from 30 to 100 poise in terms of ICI melt viscosity at 150°C from the viewpoint of the excellent fluidity of the resin and the excellent balance between heat resistance and flame retardancy of the cured article.

The phenol resin (I) preferably contains nitrogen atoms in 2 to 13% by mass in the molecular structure. As described above, since the triazine skeleton contained in the resin efficiently contributes to the flame retardancy, the phenol resin (I) exerts an excellent flame retardancy even when the amount of nitrogen atoms is decreased. Therefore, it is worthy of special mentioned that an excellent flame retardancy is exerted even when the amount of nitrogen atoms is drastically decreased as compared with the amount of nitrogen atoms of about 20% by mass like a conventional ATN resin. As described above, the amount of nitrogen atoms in the phenol resin (I) can be decreased and the melt viscosity of the phenol resin (I) decreases, and thus fluidity upon melting is remarkably improved. Consequently, workability is remarkably improved by a decrease in the viscosity of a varnish in applications such as printed circuit boards. The content of nitrogen atoms in the phenol resin (I) can be determined by calculating from the total mass of raw material components charged, the charged mass of the compound (x2) and the compound (x4) and the mass of nitrogen atoms.

Furthermore, the molecular weight distribution (Mw/Mn) of the phenol resin (I) is preferably within a range of 2 to 5. When Mw/Mn is 2 or more, solvent solubility is improved. In contrast, when Mw/Mn is 5 or less, the flame retardancy is improved.

In order to impart both contradictory performances, heat resistance and flame retardancy, to the phenol resin (I), the amount of carboxyl groups in the phenol resin (I) is preferably adjusted to be within a proper range. For example, the content of carboxyl groups is preferably within a range which satisfies a carboxyl group equivalent of 500 to 1,500 g/equivalent. The content of carboxyl groups in the phenol resin (I) can be determined by calculating from the total mass of raw material components charged, the mass of the compound (x2) charged, and the mass of carboxyl groups.

Examples of the curing agent (II) in the phenol resin composition of the present invention include an aliphatic bismaleimide having a structure in which two maleimides are linked by an alkylene group and a polyoxyalkylene group, an aromatic bismaleimide having a structure in which two maleimides are linked by a phenylene group and a biphenylene group, a polyfunctional maleimide compound in which a maleimide group is bonded to an aromatic core of a phenol novolak resin via an alkyl group, hexamine, and an epoxy resin. In applications such as electric and electronic components, an epoxy resin is particularly preferable from the viewpoint that the resulting cured article has excellent electrical characteristics such as a low dielectric constant and a low dielectric dissipation factor and also the remarkable effect of improving heat resistance is exerted.

Examples of the epoxy resin include epoxy resins derived from dihydric phenols, such as a bisphenol A type epoxy resin, a bisphenol F type epoxy resin, a bisphenol S type epoxy resin, a bisphenol AD type epoxy resin, a resorcin type epoxy resin, a hydroquinone type epoxy resin, a catechol type epoxy resin, a dihydroxynaphthalene type epoxy resin, a biphenyl type epoxy resin, and a tetramethylbiphenyl type epoxy resin; epoxy resins derived from tri- or higher polyhydric phenols, such as a phenol novolak type epoxy resin, a cresol novolak type epoxy resin, a triphenylmethane type epoxy resin, a tetraphenylethane type epoxy resin, a dicyclopentadiene-phenol modified type epoxy resin, a phenolaralkyl type epoxy resin, a biphenylaralkyl type epoxy resin, a naphthol novolak type epoxy resin, a naphtholaralkyl type epoxy resin, a naphthol-phenol condensed novolak type epoxy resin, a naphthol-cresol condensed novolak type epoxy resin, an aromatic hydrocarbon formaldehyde resin modified phenol resin type epoxy resin, and a biphenyl modified novolak type epoxy resin; and epoxy resins modified with organophosphorus compounds.

Furthermore, epoxy resins obtained by glycidylation of a phenolic hydroxyl group in the phenol resin composition may be used as the curing agent (II).

In order to obtain an epoxy resin by glycidylation of the phenol resin (I), for example, the phenol resin (I) may be reacted with epihalohydrins such as epichlorohydrin, epibromohydrin, and β-methylepichlorohydrin using a conventional method.

The composition ratio of the phenol resin (I) to the epoxy group in the epoxy resin corresponds a molar ratio of a phenolic hydroxyl group in the phenol resin (I) to an epoxy group in the epoxy resin (phenolic hydroxyl group/epoxy group), is preferably from 0.8 to 1.2 from the viewpoint of curability and heat resistance of the cured article.

The phenol resin composition of the present invention contains the phenol resin (I) and the curing agent (II) as essential components. It is also possible to use it in combination with a phenol novolak resin, a cresol novolak resin, an aromatic hydrocarbon formaldehyde resin-modified phenol resin, a phenol aralkyl resin, a cresol aralkyl resin, a naphthol aralkyl resin, a biphenyl-modified phenol resin, a phenoltrimethylolmethane resin, a tetraphenolethane resin, a naphthol novolak resin, a naphthol-phenol co-codensed novolak resin, a naphthol-cresol co-condensed novolak resin, a biphenyl modified phenol resin, an aminotriazine modified phenol resin, a bisphenol A novolak resin, and a bisphenol F novolak resin according to the applications and required characteristics.

A curing accelerator can also be used appropriately so as to allow a curing reaction between the phenol resin (I) and the curing agent (II) to proceed quickly. Examples of the curing accelerator include a phosphorous-based compound, a tertiary amine, imidazole, an organic acid metal salt, Lewis acid, and an amine complex salt.

It is possible to optionally add various compound agents such as inorganic fillers, thermocurable and thermoplastic resins used as modifiers, flame retardants, pigments, silane coupling agents, and releasants to the phenol resin composition of the present invention according to the applications.

Examples of the inorganic filler include fused silica, crystalline silica, alumina, silicon nitride, aluminum hydroxide, and magnesium hydroxide. Of these inorganic fillers, fused silica is particularly preferable from the viewpoint that the filling rate of the inorganic filler can be increased. Both crushed fused silica and spherical fused silica can be used and spherical fused silica is preferably used so as to increase the amount of the fused silica and to suppress an increase of melt viscosity of a molding material. It is preferable that the particle size distribution of the spherical silica is properly adjusted so as to increase the amount of the spherical silica.

The preferable amount of the inorganic filler varies depending on the applications and desired characteristics. When used in applications such as semiconductor encapsulating materials, the amount is preferably higher from the viewpoint of a linear expansion coefficient and flame retardancy, and is preferably from 65 to 95% by mass, and particularly preferably from 85 to 95% by mass, based on the entire amount of the phenol resin composition. When used in applications such as conductive pastes and conductive films, conductive fillers such as silver and copper powders can be used.

Various thermocurable resins and thermoplastic resins can be used as the modifier, and examples thereof include a phenoxy resin, a polyamide resin, a polyimide resin, a polyetherimide resin, a polyethersulfone resin, a polyphenyleneether resin, a polyphenylene sulfide resin, a polyester resin, a polystyrene resin, and a polyethylene terephthalate resin.

Examples of the flame retardant include a halogen compound, a phosphorus atom-containing compound, a nitrogen atom-containing compound, and an inorganic flame retardant compound. Specific examples thereof include halogen compounds such as a tetrabromobisphenol A type epoxy resin and a bromated phenol novolak type epoxy resin; phosphorus atom-containing compounds, for example, phosphate esters such as trimethyl phosphate, triethyl phosphate, tributyl phosphate, tri-2-ethylhexyl phosphate, tributoxyethyl phosphate, triphenyl phosphate, tricresyl phosphate, trixylenyl phosphate, cresyldiphenyl phosphate, xylenyldiphenyl phosphate, 2-ethylhexyldiphenyl phosphate, tris(2,6-dimethylphenyl) phosphate, and resorcin diphenyl phosphate, and condensed phosphate ester compounds such as ammonium polyphosphate, polyphosphoric acid amide, red phosphorus, phosphoric acid guanidine, and dialkylhydroxymethyl phosphonate; nitrogen atom-containing compounds such as melamine; and inorganic flame retardant compounds such as aluminum hydroxide, magnesium hydroxide, zinc borate, and calcium borate. However, since the phenol resin composition of the present invention is characterized in that it exerts an excellent flame retardancy even when a halogen-based flame retardant with a high environmental burden is not used, phosphorus atom-containing compounds, nitrogen atom-containing compounds and inorganic flame retardant compounds are preferably used among the above flame retardants.

The phenol resin composition of the present invention can be obtained by uniformly mixing the above phenol resin (I) and a curing agent (II) with optional compound agents. In this case, in order to improve workability, the viscosity may be adjusted according to applications and thermocuring conditions. Examples of the usable solvent include, but are not limited to, solvents having a boiling point of 160°C or lower, for example, alcoholic solvents such as methanol, ethanol, isopropyl alcohol, methyl cellosolve, and ethyl cellosolve, aromatic hydrocarbonic solvents such as toluene and xylene, and non-alcoholic polar solvents such as acetone, methyl ethyl ketone, methyl isobutyl ketone, cyclohexanone, and dimethylformamide; and N-methyl pyrrolidone. It is preferable to make an appropriate selection according to the applications and thermocuring conditions. The phenol resin (I) and the curing agent (II) may be mixed after preliminarily adding the solvent to one of them. Alternatively, the phenol resin composition, the epoxy resin and optional various compound agents may be mixed and then the solvent may be added so as to adjust the viscosity, followed by uniform mixing.

There is no limitation on the thermocuring conditions of the phenol resin composition of the present invention, and the phenol resin can be cured under conventional curing conditions. The curing temperature may be the same as or higher than the temperature at which the resin component is softened, and is usually 120°C or higher and 200°C or lower. The curing temperature is particularly preferably within a range of 130 to 180°C from the viewpoint of good moldability. After molding, the molded article is preferably calcined so as to obtain a friction material having an excellent heat resistance.

Since the resulting cured article of the above-mentioned phenol resin composition of the present invention has excellent dielectric characteristics when an epoxy resin is used as the curing agent (II), in addition to a resin composition for a resist ink and a binder for a friction material, it can be used in a resin composition for a copper-clad laminate, a resin composition for a encapsulating material of electronic components, a conductive paste, a resin casting material, an adhesive, and a coating material such as an insulating coating material.

The method of using the phenol resin composition of the present invention as the resin composition for a resist ink includes, for example, a method of adding an organic solvent, a pigment, a talc and a filler to the phenol resin (I) and the curing agent (II) to prepare a composition for a resist ink, applying the composition for a resist ink on a printed circuit board using screen print and curing the composition to obtain a resist ink cured article. Examples of the organic solvent include methyl cellosolve, ethyl cellosolve, methyl cellosolve acetate, ethyl cellosolve acetate, cyclohexanone, dimethyl sulfoxide, dimethylformamide, dioxolane, tetrahydrofuran, propylene glycol monomethylether acetate, and ethyl lactate.

When the phenol resin composition of the present invention is used in the binder for a friction material, the binder can be prepared by using a substance capable of generating formaldehyde under heating such as hexamethylenetetramine or paraformaldehyde as the curing agent (II) and mixing with a curing accelerator such as imidazole or a derivative thereof, a carboxylic acid compound, amines or a BF₃ amine compound. In order to prepare a friction material using such a binder for a friction material, for example, a method of adding a filler and an additive to the above components and thermocuring the mixture and a method of impregnating a fiber base material with the above components and thermocuring the impregnated fiber base material can be employed. Examples of the filler and the additive used herein include silica, barium sulfate, calcium carbonate, silicon carbide, polymerized cashew oil, molybdenum disulfide, aluminum hydroxide, talc, clay, black lead, graphite, rubber particles, aluminum powder, copper powder, and brass powder.

When used as the binder for a friction material, a method of using this phenol resin composition in combination with a fiber base material and a curing agent followed by thermocuring can be employed. Examples of the fiber base material include inorganic fibers such as a glass fiber, ceramic fiber, asbestos fiber, carbon fiber, and stainless steel fiber; natural fibers such as cotton and hemp fibers; and synthetic organic fibers such as polyester and polyamide fibers. Examples of the shape of the fiber base material include short fiber, long fiber, yarn, mat, and sheet.

The method of producing a resin composition for a copper-clad laminate from the phenol resin composition of the present invention includes, for example, a method of preparing a varnish using the phenol resin (I), an epoxy resin as the curing agent (II), and an organic solvent.

Examples of the organic solvent include solvents include alcoholic solvents such as methanol, ethanol, isopropyl alcohol, methyl cellosolve, ethyl cellosolve, and propylene glycol monomethyl ether; aromatic hydrocarbonic solvents such as toluene and xylene; non-alcoholic polar solvents such as acetone, methyl ethyl ketone, methyl isobutyl ketone, cyclohexanone, dimethylformamide, N-methyl pyrrolidone, and dimethyl acetamide.

The method of producing a copper-clad laminate from the resin composition for a copper-clad laminate includes, for example, the following method.

Various reinforced base materials such as paper, a glass fabric, a glass nonwoven fabric, an aramid paper, an aramid fabric, a glass mat, and a glass roving fabric are impregnated with a varnish composition prepared by using the phenol resin (I), an epoxy resin as the curing agent (II) and an organic solvent, and then heated at a heating temperature selected according to the kind of the solvent, preferably 50 to 170°C, to obtain a prepreg as a cured article. In this case, the mixing ratio of the phenol resin composition to the reinforced base material is preferably adjusted so as to control the content of the resin in the prepreg within a range of 20 to 60% by mass.

The resulting prepregs are laminated and copper foils are further laminated, followed by contact bonding with heating under a pressure of 1 to 10 MPa at 170 to 250°C from 10 minutes to 3 hours to obtain the objective copper-clad laminate.

The resin composition for a copper-clad laminate of the present invention is also very useful as an interlayer insulation material of a buildup printed circuit board. The interlayer insulation material of the buildup printed circuit board can be obtained by a method of mixing the phenol resin (I), an epoxy resin as the curing agent (II), the organic solvent, a rubber and a filler among the above methods for preparing a varnish. The method for producing a buildup substrate from the thus obtained interlayer insulation material for a buildup substrate includes, for example, the following method.

The interlayer insulation material for a buildup substrate is applied on a wiring board with a circuit formed thereon using a spray coating method or a curtain coating method and predetermined through-holes are optionally formed. The surface is treated with a roughening agent and washed with hot water to form unevenness, followed by a plating treatment with metal such as copper. The plating treatment is preferably an electroless plating or electroplating treatment, and the roughening agent is an oxidizing agent, an alkali or an organic solvent. A buildup substrate can be obtained by optionally repeating such an operation sequentially to alternately buildup a resin insulating layer and a conductor layer of a predetermined circuit pattern. Through-holes are preferably formed after forming the resin insulating layer as an outermost layer. By contact-bonding a resin-coated copper foil, which is formed by semicuring the resin composition on a copper foil, on a wiring board with a circuit formed thereon with heating at 170 to 250°C, a buildup substrate can be produced without forming a roughened surface or performing the plating treatment.

Specific examples of the application when the phenol resin composition of the present invention is used as the resin composition for a encapsulating material of electronic components include a semiconductor encapsulating material, a tape-shaped encapsulating agent of semiconductors, a potting type liquid encapsulating agent, an under-filling resin, and an interlayer dielectric film of semiconductors.

The phenol resin composition of the present invention is prepared for a semiconductor encapsulating material using a method of preliminarily mixing the phenol resin (I), an epoxy resin as the curing agent (II), optional additives such as coupling agents and releasing agents, and inorganic fillers and sufficiently mixing using an extruder, a kneader or a roll until a uniform mixture is obtained.

When used as the tape-shaped encapsulating agent of semiconductors, it can be obtained by a method of heating a resin composition obtained by the above technique to form a semicured sheet, converting into a encapsulating agent tape, placing the encapsulating agent tape on a semiconductor chip, heating to a temperature of 100 to 150°C thereby softening and molding, and completely curing it at a temperature of 170 to 250°C.

When used as the potting type liquid encapsulating agent, the resin composition obtained by the above technique is optionally dissolved in a solvent and the solution is applied on a semiconductor chip or electronic components, and then directly cured.

When the phenol resin composition of the present invention is used as the under-filling resin, the resin can be obtained by a compression flow method of preliminarily applying the phenol resin composition of the present invention on a substrate or a semiconductor device, semicuring and heating, thereby adhering the semiconductor device to the substrate, and completely curing the resin composition.

The method of using the phenol resin composition of the present invention as the interlayer insulation material of semiconductors includes, for example, a method of mixing a curing accelerator and a silane coupling agent, in addition to the phenol resin (I) and an epoxy resin as the curing agent (II) to prepare a composition, and applying the composition on a silicone substrate using a spin coating method. In this case, since a cured coating film is directly contacted with a semiconductor, a linear expansion coefficient of the insulating material is preferably adjusted to a value close to the linear expansion coefficient of the semiconductor so as to prevent from cracking due to a difference of linear expansion coefficients under a high temperature environment.

The method for preparing a conductive paste from the phenol resin composition of the present invention includes, for example, a method of dispersing fine conductive particles in the phenol resin composition to prepare a composition for an anisotropic conductive film, and a method of preparing a paste resin composition for connection of circuits or an anisotropic conductive adhesive which is liquid at room temperature.

The method of preparing a resin composition for an adhesive from the phenol resin composition of the present invention includes, for example, a method of uniformly mixing the phenol resin (I), curing agent (II) and optional resins, curing accelerators, solvents and additives at room temperature or under heating using a mixer. It is possible to bond to various base materials by applying the resin composition, followed by standing at room temperature or under heating.

The method of preparing a composite material from the phenol resin composition of the present invention includes, for example, a method of preparing a varnish from the phenol resin (I) and the curing agent (II) using an organic solvent so as to adjust to a viscosity suited for purposes, impregnating a reinforced base material with the varnish, heating the impregnated reinforced base material to obtain a prepreg, and then laminating prepregs so as to impart pseudo-isotropy by gradually changing the direction of the fiber, at last curing and forming with heating. Examples of the usable organic solvent include solvents having a boiling point of 160°C or lower, for example, alcoholic solvents such as methanol, ethanol, isopropyl alcohol, methyl cellosolve, and ethyl cellosolve; aromatic hydrocarbonic solvents such as toluene and xylene; and non-alcoholic polar solvents such as acetone, methyl ethyl ketone, methyl isobutyl ketone, cyclohexanone, and dimethylformamide. The heating temperature can be appropriately selected according to the kind of the solvent to be used, but is preferably within a range of 50 to 150°C. Examples of the reinforced base material include a carbon fiber, a polyester fiber, a polyamide fiber, an alumina fiber, paper, a glass fabric, a glass nonwoven fabric, an aramid paper, an aramid fabric, a glass mat, and a glass roving fabric. There is no limitation on the mixing ratio of the resin component and the reinforced base material, and the content of the resin component in the prepreg is preferably set within a range of 20 to 60% by mass.

The phenol resin composition of the present invention is particularly useful as a resin composition for a copper-clad laminate among various applications described above from the viewpoint of it can have both excellent flame retardancy and heat resistance, although it is a halogen-free curing system with a low environmental burden.

The cured article of the present invention is obtained by molding and curing the above-described phenol resin composition of the present invention and can be used as laminates, cast articles, adhesives, coating films, and films according to the purposes. As described above, the cured article is particularly useful as a copper-clad laminate for a printed circuit board.

In order to cure the phenol resin composition of the present invention, the phenol resin composition may be appropriately thermocured under proper temperature conditions according to selection of the curing agent (II), other components and applications. Specifically, it is preferable to perform curing under temperature conditions of 25 to 200°C.

### EXAMPLES

The present invention will be described in detail below by way of Examples and Comparative Examples. In the following, parts and percentages are by weight.

The triazine compound (x2) having a carboxyl group-containing aromatic hydrocarbon group and an amino group as substituents on a triazine ring used in the following Examples is benzoic acid guanamine (hereinafter abbreviated to "BAG") represented by structural formula (4) shown below, manufactured by KK. NISSEI KAGAKU KOGYOSHO.

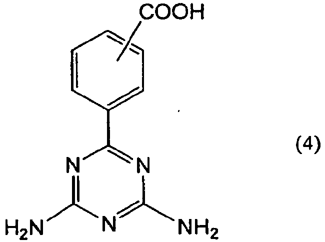

The presence or absence of a methylol group of phenol resins obtained in the following Examples and Comparative Examples, and the presence or absence of the unreacted phenols (x1) and the unreacted aldehydes (x3), and the molecular weight distribution were determined by the following procedures.

### <Presence or Absence of Aromatic Substituted Methylol Group and Methylol Group>

Using ¹³C-NMR, the presence or absence of a methylol group in a resin composition was examined.

Apparatus: "GSX270 Proton" manufactured by JEOL Ltd.: 270MHz, Measuring
Solvent: deuterated methanol or deuterated acetone, deuterated dimethyl sulfoxide
Reference Material: tetramethylsilane

In the resulting chart, judgment was carried out using a peak within a range of 55 to 70 ppm which can be clearly distinguished from noise. The case where a peak is observed was rated "observed", while the case where a peak is not observed was rated "not observed".

### <Content of Unreacted Phenols (x1)>

Column: 30% celite 545 carnauba wax 2 m × 3 mm ϕ
Column Temperature: 170°C
Inlet temperature: 230°C
Detector: FID
Carrier gas: N₂ gas, 1.0 kg/cm²
Measuring Method: Under measuring conditions of an internal standard method, the amount of a monofunctional phenol in the phenol resin (I) was measured.

### <Presence or Absence of Unreacted Aldehydes (x3)>

Using FT-IR, the presence or absence of unreacted aldehydes in the phenol resin (I) during the reaction was examined.

Apparatus: FT/IR-500 manufactured by JASCO Corporation

A reaction mixture was applied on a KBr plate and judgment was carried out using a peak attributed to an aldehyde group observed at about 1700 cm⁻¹ of the resulting chart. The case where a peak is observed was rated "observed", while the case where a peak is not observed was rated "not observed".

### <Molecular Weight Distribution>

Using the following apparatus, molecular weight distribution was measured under the following measuring conditions.
Apparatus: "HLC-8220GPC" manufactured by TOSOH CORPORATION
Column: G2000HXLx2, G3000HXL, G4000HXL 7.8 mm ϕ × 300 mm
Column temperature: 40°C
Detector: RI
Carrier solvent: tetrahydrofuran
Flow rate: 1.0 ml/min.
Measuring method: Under the same measuring conditions as in a polystyrene standard method, the molecular weight distribution of the phenol resin (I) was measured.

### <Content of Nitrogen Atom in Phenol Resin>

The content of a nitrogen atom in a phenol resin was calculated from the total charge mass of a raw material component, the charge mass of a compound (x2) and a compound (x4), and the mass of a nitrogen atom.

### <Carboxyl Group Equivalent>

The carboxyl group equivalent was calculated from the total charge mass of a raw material component, the charge mass of a compound (x2) and the mass of a carboxyl group.

### Example 1

In a reactor equipped with a condenser, a normal pressure distillation apparatus and a vacuum distillation apparatus, 940 parts of phenol, 185 parts of BAG, 434 parts of 41.5% formalin and 3 parts of triethylamine were charged and then after heating to 115°C, the reaction was carried out for 2 hours. The temperature was raised to 135°C while normal pressure distillation is carried out, and the reaction was carried out for 2 hours. The temperature was raised to 180°C while normal pressure distillation is carried out again and vacuum distillation was conducted at 180°C, thereby removing the low boiling point component such as the unreacted monomer and water to obtain 780 parts of a resin having a softening point of 123°C. Hereinafter, this resin is referred to as "phenol resin (A-1)".

A methylol group and unreacted aldehydes did not exist in a solid content of the resulting phenol resin (A-1) and the amount of the unreacted phenol monomer was 0.1 % by mass.

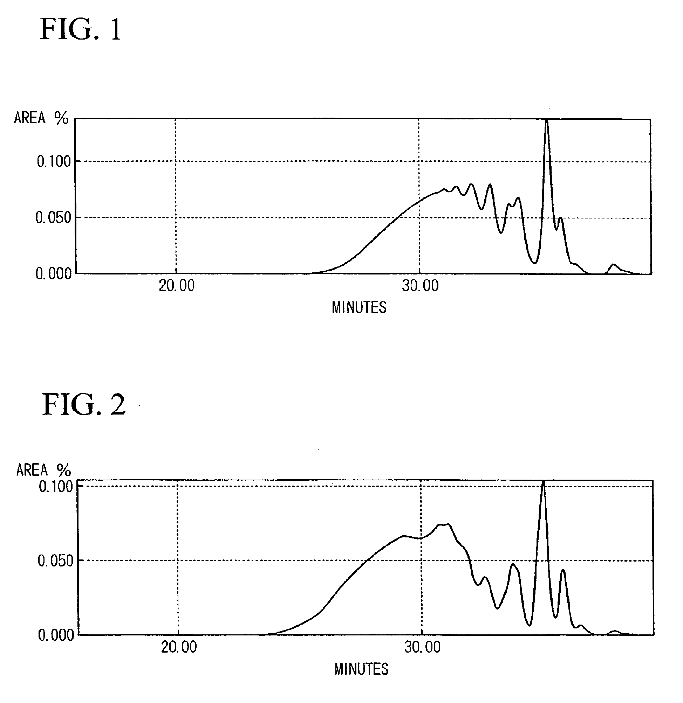

The measurement results of the molecular weight distribution are shown in Fig. 1.

The content of a nitrogen atom of the phenol resin (A-1) was 7.2% by mass, the carboxyl group equivalent was 975 g/equivalent, the ICI melt viscosity at 150°C was 55 poise, and the molecular weight distribution (Mw/Mn) was 2.46.

### Example 2

In the same manner as in Example 1, except that 1080 parts of o-cresol was charged, the reaction was carried out to obtain 840 parts of a resin having a softening point of 116°C. Hereinafter, this resin is referred to as "phenol resin (A-2)". A methylol group and unreacted aldehydes did not exist in a solid content of the resulting phenol resin and the amount of the unreacted phenol monomer was 0.2% by mass. The measurement results of molecular weight distribution are shown in Fig. 2.

The content of a nitrogen atom of the phenol resin (A-2) was 6.6% by mass, the carboxyl group equivalent was 1,050 g/equivalent, the ICI melt viscosity at 150°C was 45 poise, and the molecular weight distribution (Mw/Mn) was 3.29.

### Example 3

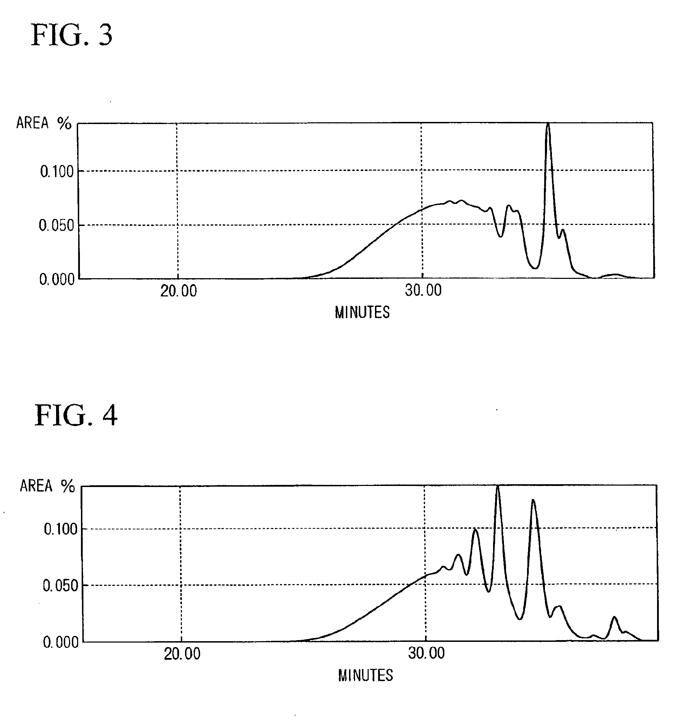

In a reactor equipped with a condenser, a normal pressure distillation apparatus and a vacuum distillation apparatus, 940 parts of phenol, 92 parts of BAG, 50 parts of melamine, 434 parts of 41.5% formalin and 3 parts of triethylamine were charged and then after heating to 100°C, the reaction was carried out for 2 hours. The temperature was raised to 135°C while normal pressure distillation was carried out, and the reaction was carried out for 2 hours. The temperature was raised to 150°C while normal pressure distillation was carried out again, and the reaction was carried out for 2 hours, followed by cooling to 95°C. In the reaction system, 170 parts of 41.5% formalin was added dropwise and then after heating to 100°C, the reaction was carried out for 2 hours. The temperature was raised to 135°C while normal pressure distillation was carried out, and the reaction was carried out for 2 hours. The temperature was raised to 180°C while normal pressure distillation was carried out again, and then vacuum distillation was conducted at 180°C, thereby removing the low boiling point component such as the unreacted monomer and water to obtain 730 parts of a resin having a softening point of 117°C. Hereinafter, this resin is referred to as "phenol resin (A-3)". A methylol group and unreacted aldehydes did not exist in a solid content of the resulting phenol resin (A-3) and the amount of the unreacted phenol monomer was 0.2% by mass. The measurement results of molecular weight distribution are shown in Fig. 3.

The content of a nitrogen atom of the phenol resin (A-3) was 8.4% by mass, the carboxyl group equivalent was 1,825 g/equivalent, the ICI melt viscosity at 150°C was 81 poise, and the molecular weight distribution (Mw/Mn) was 2.95.

### Comparative Example 1

In a reactor equipped with a condenser, a normal pressure distillation apparatus and a vacuum distillation apparatus, 940 parts of phenol, 151 parts of melamine and 434 parts of 41.5% formalin were charged and then after heating to 100°C, the reflux reaction was carried out for 2 hours. The temperature was raised to 135°C while normal pressure distillation was carried out, and the reflux reaction was carried out for 2 hours. The temperature was raised to 180°C while normal pressure distillation was carried out again, and then vacuum distillation was conducted at 180°C, thereby removing the low boiling point component such as the unreacted monomer and water to obtain 740 parts of a resin having a softening point of 136°C. Hereinafter, this resin is referred to as "phenol resin (A'-1)". A methylol group and unreacted aldehydes did not exist in a solid content of the resulting phenol resin and the amount of the unreacted phenol monomer was 0.9% by mass. The measurement results of molecular weight distribution are shown in Fig. 4.

The content of a nitrogen atom of the phenol resin (A'-1) was 13.6% by mass, the ICI melt viscosity at 150°C was 100 poise, and the molecular weight distribution (Mw/Mn) was 2.84.

### Examples 4 to 6 and Comparative Examples 2 to 4

According to the compositions shown in Table 1, phenol resin compositions were prepared by the following method and then cured under conditions shown below to produce a double-sided copper-clad laminate, and then various evaluations were carried out. The results are shown in Table 1.

### <Preparation of Epoxy Resin Composition>

The phenol resin (A-1), the phenol resin (A-2), the phenol resin (A-3) or the phenol resin (A'-1) obtained in the above respective Examples and Comparative Examples were mixed with an epoxy resin (B), and then the nonvolatile content (N.V.) of each composition was finally adjusted to 55% by mass.

### <Conditions of Production of Laminate>

Base material: 180 µm, glass cloth "WEA 7628 H258" manufactured by Nitto Boseki Co., Ltd.
Number of ply: 8
Conditions of formation of prepreg: 160°C/2 min.
Copper foil: 35 µm, manufactured by Furukawa Circuit Wheel
Curing conditions: 200°C, 40 kg/cm² for 1.5 hours
Thickness after molding into plate: 1.6 mm
Resin content: 40%
<Conditions of Test on Physical Properties>
Molding conditions: After subjecting to an etching treatment and removing a copper foil, the appearance was visually observed. Samples which are free from chipping, thin spot and measling and are uniformly molded were rated "Good".

Glass Transition Temperature: After subjecting to an etching treatment and removing a copper foil, the glass transition temperature is measured by a DMA method. Heating speed: 3°C/min.
Moisture Absorptivity: After subjecting to an etching treatment and removing a copper foil, a test piece (25 mm × 50 mm) was allowed to stand for 2 hours under the conditions of 121 °C, 2.1 atm and 100%RH using a pressure cooker testing machine, and then the change in weight before and after the test was measured.
Dielectric Characteristics: After subjection to an etching treatment and removing a copper foil, a dielectric constant and a dielectric dissipation factor at a frequency of 100 MHz and 1 GHz were measured using a device for evaluation of dielectric characteristics (size of test piece: 75 mm × 25 mm × 2mm).
Combustion Test: After subjection to an etching treatment and removing a copper foil, a varnish for a combustion test was prepared by dispersing an aluminum hydroxide in a proportion of 30% by mass based on the solid content in the epoxy resin composition, and then a laminate was made under the same conditions as in the case of making the above laminate. A test was carried out in accordance with UL-94 Vertical Test. Oven Heat Resistance: Using a constant temperature bath equipped with an air circulation device, a test piece (50 mm × 50 mm) was treated for one hour under the conditions of 220°C, 240°C and 260°C. Test pieces free from blister and peeling on one face and end surfaces were rated "Good".

**Table 1: Composition Table of Phenol Resin Composition (Parts) and Evaluation Results of Cured Article**

| | | | Examples | | | Comparative Examples | |
|---|---|---|---|---|---|---|---|
| | | | 4 | 5 | 6 | 2 | 3 |
| Parts | Phenol resin (A-1)+ | | 70 | | | | |
| | Phenol resin (A-2) | | | 70 | | | |
| | Phenol resin (A-3) | | | | 70 | | |
| | Phenol resin (A'-1) | | | | | 70 | |
| | Epoxy resin: N-673 | | 130 | 130 | 130 | 130 | |
| | Epoxy resin: N-690 | | | | | | 20 |
| | Epoxy resin: 1121-N-80M | | | | | | 220 |
| | MEK | | 164 | 164 | 164 | 164 | 60 |
| | DMF | | | | | | 60 |
| | Dicyandiamide | | | | | | 5 |
| | 2-ethyl-4-methylimidazole | | | | | | 0.1 |
| | (Aluminum hydroxide, mixed only when a combustion test is carried out) | | (86) | (86) | (86) | (86) | |
| Molded state | | | Good | Good | Good | Good | Good |
| Glass transition temperature Tg (DMA) °C | | | 200 | 198 | 204 | 211 | 151 |
| Moisture absorptivity % | | | 0.30 | 0.27 | 0.32 | 0.47 | 0.52 |
| Dielectric constant | | 10 MHz | 4.2 | 4.2 | 4.2 | 4.3 | 4.4 |
| | | 1 GHz | 4.2 | 4.1 | 4.2 | 4.4 | 4.2 |
| Dielectric dissipation factor | | 10 MHz | 0.012 | 0.011 | 0.012 | 0.013 | 0.016 |
| | | 1 GHz | 0.014 | 0.011 | 0.013 | 0.014 | 0.016 |
| Combustion test | | | V-0 | V-0 | V-0 | Self-extinguishing | V-0 |
| Oven heat resistance | | 220°C | Good | Good | Good | Good | Good |
| | | 240°C | Good | Good | Good | Good | Poor |
| | | 260°C | Good | Good | Good | Poor | Poor |

Raw materials and abbreviations in Table 1 are as follows. "N-673": cresol novolak type epoxy resin (manufactured by Dainippon Ink and Chemicals, Inc. under the trade name of EPICLON N-673, epoxy equivalent: 211 g/eq.) "N-690": cresol novolak type epoxy resin (manufactured by Dainippon Ink and Chemicals, Inc. under the trade name of EPICLON N-690, epoxy equivalent: 216 g/eq.) "1121N-80M": brominated epoxy resin (manufactured by Dainippon Ink and Chemicals, Inc. under the trade name of EPICLON 1121N-80M, epoxy equivalent: 490 g/eq. (solid content), nonvolatile content: 80%)
"MEK": methyl ethyl ketone
"DMF": dimethylformamide

## Claims

1. A phenol resin composition comprising a phenol resin (I) having a chemical structure (A) in which an aromatic hydrocarbon group substituted with a carboxyl group is bonded to a triazine ring, as a partial structure in the molecular structure, and a curing agent (II).

2. The phenol resin composition according to claim 1, wherein the chemical structure (A) in the phenol resin (I) is represented by structural formula (1) shown below: 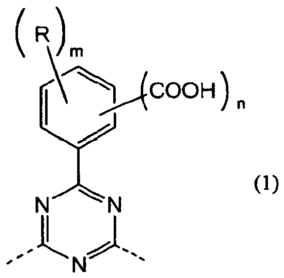 wherein R represents a hydrogen atom, an aliphatic hydrocarbon group having 1 to 4 carbon atoms, an aromatic hydrocarbon group, a bromine atom, or a chlorine atom, the broken line portion represents a bond with the other molecular structure, and n and m represent integers of 1 to 4.

3. The phenol resin composition according to claim 1, wherein the phenol resin (I) having a chemical structure (A) in which an aromatic hydrocarbon group substituted with a carboxyl group is bonded to a triazine ring, as a partial structure in the molecular structure, has a molecular structure obtained by reacting phenols (x1), a triazine compound (x2) having a carboxyl group-containing aromatic hydrocarbon group and an amino group as substituents on the triazine ring, and aldehydes (x3).

4. The phenol resin composition according to claim 3, wherein the triazine compound (x2) having a carboxyl group-containing aromatic hydrocarbon group and an amino group as substituents on the triazine ring is a compound represented by structural formula (2) shown below: 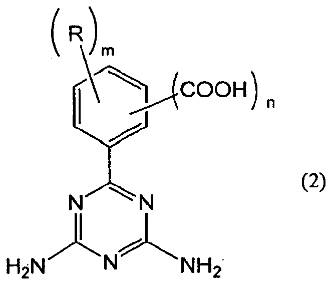 wherein R represents a hydrogen atom, an aliphatic hydrocarbon group having 1 to 4 carbon atoms, an aromatic hydrocarbon group, a bromine atom, or a chlorine atom, and n and m represent integers of 1 to 4.

5. The phenol resin composition according to claim 3, wherein the phenol resin (I) is obtained by further reacting with another amino group-containing triazine compound (x4) except for the triazine compound (x2), in addition to the phenols (x1), the compound (x2) and the aldehydes (x3).

6. The phenol resin composition according to claim 5, wherein the amino group-containing triazine compound (x4) is at least one compound selected from the group consisting of melamine, acetoguanamine and benzoguanamine.

7. The phenol resin composition according to claim 1, wherein an ICI melt viscosity of the phenol resin (I) at 150°C is100 poise or less.

8. The phenol resin composition according to claim 1, wherein the phenol resin (I) contains a nitrogen atom in the proportion of 2 to 13% by mass in the molecular structure.

9. The phenol resin composition according to claim 8, wherein the phenol resin (I) contains a carboxyl group contained in the resin in a carboxyl group equivalent within a range of 500 to 1,500 g/equivalent.

10. The phenol resin composition according to claim 1, wherein the curing agent (II) is an epoxy resin.

11. The phenol resin composition according to claim 10, wherein a composition ratio of the phenol resin (I) to the epoxy resin corresponds to a molar ratio of a phenolic hydroxyl group in the phenol resin (I) to an epoxy group contained in the epoxy resin (phenolic hydroxyl group/epoxy group), wherein the molar ratio is the range of 0.8 to 1.2.

12. A cured article which is obtained by thermocuring the phenol resin composition according to any one of claims 1 to 11.

13. A resin composition for a copper-clad laminate, comprising the phenol resin composition according to any one of claims 1 to 11 and an organic solvent.

14. A copper-clad laminate which is obtained by a process comprising the steps of impregnating a glass cloth with the resin composition according to claim 13 to obtain a prepreg, laminating a plurality of prepregs and copper foils, and curing.

15. A phenol resin which has a molecular structure obtained by reacting phenols (x1), a triazine compound (x2) having a carboxyl group-containing aromatic hydrocarbon group and an amino group as substituents on a triazine ring, and aldehydes (x3), and also has a structural site represented by structural formula (1) shown below: 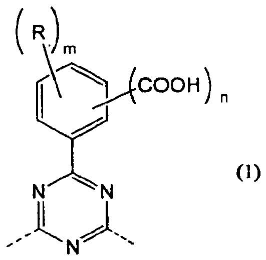 wherein R represents a hydrogen atom, an aliphatic hydrocarbon group having 1 to 4 carbon atoms, an aromatic hydrocarbon group, a bromine atom, or a chlorine atom, the broken line portion represents a bond with the other molecular structure, and n and m represent integers of 1 to 4, in the molecular structure, wherein an ICI melt viscosity of the phenol resin at 150°C is 10 Pa.s (100 poise) or less.

16. The phenol resin according to claim 15, wherein the the phenol resin is obtained by further reaction with another amino group-containing triazine compound (x4) except for the triazine compound (x2), in addition to the phenols (x1), the compound (x2) and the aldehydes (x3).

17. The phenol resin composition according to claim 15 or 16, wherein the phenol resin contains a nitrogen atom in the proportion of 2 to 13% by mass in the molecular structure.

18. The phenol resin composition according to claim 15 or 16, wherein the phenol resin contains a carboxyl group contained in the resin in a carboxyl group equivalent within a range of 500 to 1,500 g/equivalent.

## Patentansprüche

1. Phenolharzzusammensetzung, umfassend ein Phenolharz (I), das eine chemische Struktur (A) hat, in der eine aromatische Kohlenwasserstoffgruppe, die mit einer Carboxylgruppe substituiert ist, an einen Triazinring gebunden ist, als Partialstruktur in der Molekülstruktur, und ein Härtungsmittel (II).

2. Phenolharzzusammensetzung gemäß Anspruch 1, wobei die chemische Struktur (A) in dem Phenolharz (I) durch die unten gezeigte Strukturformel (1) dargestellt wird: 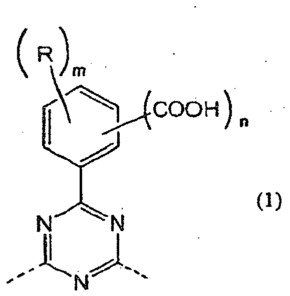 worin R ein Wasserstoffatom, eine aliphatische Kohlenwasserstoffgruppe mit 1 bis 4 Kohlenstoffatomen, eine aromatische Kohlenwasserstoffgruppe, ein Bromatom oder ein Chloratom darstellt, der gestrichelten Linienteil eine Bindung mit der anderen Molekülstruktur darstellt und n und m ganze Zahlen von 1 bis 4 darstellen.

3. Phenolharzzusammensetzung gemäß Anspruch 1, wobei das Phenolharz (I), das eine chemische Struktur (A), in der eine aromatische Kohlenwasserstoffgruppe, die mit einer Carboxylgruppe substituiert ist, an einen Triazinring gebunden ist, als Partialstruktur in der Molekülstruktur hat, eine Molekülstruktur hat, die durch Umsetzen von Phenolen (x1), einer Triazinverbindung (x2), die eine Carboxylgruppe-enthaltende aromatische Kohlenwasserstoffgruppe und eine Aminogruppe als Substituenten am Triazinring hat, und Aldehyden (x3) erhalten wird.

4. Phenolharzzusammensetzung gemäß Anspruch 3, wobei die Triazinverbindung (x2), die eine Carboxylgruppe-enthaltende aromatische Kohlenwasserstoffgruppe und eine Aminogruppe als Substituenten am Triazinring hat, eine Verbindung ist, die durch die unten angeführte Strukturformel (2) dargestellt wird: 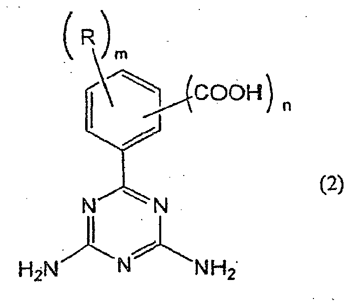 worin R ein Wasserstoffatom, eine aliphatische Kohlenwasserstoffgruppe mit 1 bis 4 Kohlenstoffatomen, eine aromatische Kohlenwasserstoffgruppe, ein Bromatom oder ein Chloratom darstellt und n und m ganze Zahlen von 1 bis 4 darstellen.

5. Phenolharzzusammensetzung gemäß Anspruch 3, wobei das Phenolharz (I) erhalten wird, indem außerdem mit einer weiteren Aminogruppe-enthaltenden Triazinverbindung (x4) außer der Triazinverbindung (x2) zusätzlich zu den Phenolen (x1), der Verbindung (x2) und den Aldehyden (x3) umgesetzt wird.

6. Phenolharzzusammensetzung gemäß Anspruch 5, wobei die Aminogruppe-enthaltende Triazinverbindung (x4) wenigstens eine Verbindung, ausgewählt aus der Gruppe, bestehend aus Melamin, Acetoguanamin und Benzoguanamin, ist.

7. Phenolharzzusammensetzung gemäß Anspruch 1, wobei die ICI-Schmelzviskosität des Phenolharzes (I) bei 150°C 100 Poise oder weniger ist.

8. Phenolharzzusammensetzung gemäß Anspruch 1, wobei das Phenolharz (I) ein Stickstoffatom in einem Verhältnisanteil von 2 bis 13 Massenprozent in der Molekülstruktur enthält.

9. Phenolharzzusammensetzung gemäß Anspruch 8, wobei das Phenolharz (I) eine Carboxylgruppe enthält, die in dem Harz mit einem Carboxylgruppenäquivalent im Bereich von 500 bis 1500 g/Äquivalent enthalten ist.

10. Phenolharzzusammensetzung gemäß Anspruch 1, wobei das Härtungsmittel (II) ein Epoxyharz ist.

11. Phenolharzzusammensetzung gemäß Anspruch 10, wobei ein Zusammensetzungsverhältnis des Phenolharzes (I) zu dem Epoxyharz ein Molverhältnis einer phenolischen Hydroxylgruppe in dem Phenolharz (I) zu einer Epoxygruppe, die in dem Epoxyharz enthalten ist (phenolische Hydroxylgruppe/Epoxygruppe) entspricht, wobei das Molverhältnis im Bereich von 0,8 bis 1,2 liegt.

12. Gehärteter Gegenstand, der durch Wärmehärtung der Phenolharzzusammensetzung gemäß einem der Ansprüche 1 bis 11 erhalten wurde.

13. Harzzusammensetzung für ein kupferplattiertes Laminat, die die Phenolharzzusammensetzung gemäß einem der Ansprüche 1 bis 11 und ein organisches Lösungsmittel umfasst.

14. Kupferplattiertes Laminat, das durch ein Verfahren erhalten wird, das die Schritte Imprägnieren eines Glasgewebes mit der Harzzusammensetzung gemäß Anspruch 13 unter Erhalt eines Prepreg, Laminieren einer Vielzahl von Prepregs und Kupferfolien und Härten umfasst.

15. Phenolharz, das eine Molekülstruktur hat, die durch Umsetzen von Phenolen (x1), einer Triazinverbindung (x2), die eine Carboxylgruppe-enthaltende aromatische Kohlenwasserstoffgruppe und eine Aminogruppe als Substituenten an einem Triazinring hat, und Aldehyden (x3) erhalten wird und auch eine Strukturstelle, die durch die unten angeführte Strukturformel (I) dargestellt wird: 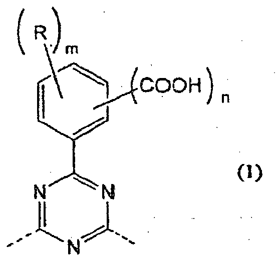 worin R ein Wasserstoffatom, eine aliphatische Kohlenwasserstoffgruppe mit 1 bis 4 Kohlenstoffatomen, eine aromatische Kohlenwasserstoffgruppe, ein Bromatom oder ein Chloratom darstellt, der unterbrochene Linienteil eine Bindung mit der anderen Molekülstruktur darstellt und n und m ganze Zahlen von 1 bis 4 darstellen, in der Molekülstruktur hat, wobei die ICI-Schmelzviskosität des Phenolharzes bei 150°C 10 Pas (100 Poise) oder weniger ist.

16. Phenolharz gemäß Anspruch 15, wobei das Phenolharz erhalten wird, indem außerdem mit einer weiteren Aminogruppeenthaltenden Triazinverbindung (x4) außer der Triazinverbindung (x2) zusätzlich zu den Phenolen (x1), der Verbindung (x2) und den Aldehyden (x3) umgesetzt wird.

17. Phenolharzzusammensetzung gemäß Anspruch 15 oder 16, wobei das Phenolharz ein Stickstoffatom im Verhältnisanteil von 2 bis 13 Massenprozent in der Molekülstruktur enthält.

18. Phenolharzzusammensetzung gemäß Anspruch 15 oder 16, wobei das Phenolharz eine Carboxylgruppe enthält, die in dem Harz mit einem Carboxylgruppenäquivalent in einem Bereich von 500 bis 1500 g/Äquivalent enthalten ist.

## Revendications

1. Composition de résine phénolique comprenant une résine phénolique (I) ayant une structure chimique (A) dans laquelle un groupe hydrocarboné aromatique substitué par un groupe carboxyle est lié à un noyau triazine, en tant que structure partielle dans la structure moléculaire, et un agent durcisseur (II).

2. Composition de résine phénolique selon la revendication 1, dans laquelle la structure chimique (A) dans la résine phénolique (I) est représentée par la formule structurelle (1) présentée ci-dessous : 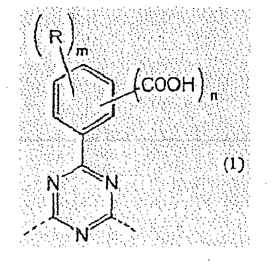 dans laquelle R représente un atome d'hydrogène, un groupe hydrocarboné aliphatique comportant 1 à 4 atomes de carbone, un groupe hydrocarboné aromatique, un atome de brome ou un atome de chlore, la partie de ligne en pointillés représente une liaison avec une autre structure moléculaire et n et m représentent des nombres entiers de 1 à 4.

3. Composition de résine phénolique selon la revendication 1, dans laquelle la résine phénolique (I) ayant une structure chimique (A) dans laquelle un groupe hydrocarboné aromatique substitué par un groupe carboxyle est lié à un noyau triazine, en tant que structure partielle dans la structure moléculaire, a une structure moléculaire obtenue par la réaction de phénols (x1), d'un composé de triazine (x2) comprenant un groupe hydrocarboné aromatique contenant un groupe carboxyle et un groupe amino en tant que substituants sur le noyau triazine, et d'aldéhydes (x3).

4. Composition de résine phénolique selon la revendication 3, dans laquelle le composé de triazine (x2) comprenant un groupe hydrocarboné aromatique contenant un groupe carboxyle et un groupe amino en tant que substituants sur le noyau triazine est un composé représenté par la formule structurelle (2) présentée ci-dessous : 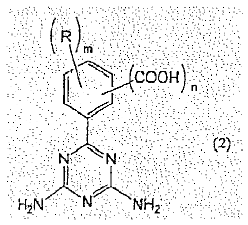 dans laquelle R représente un atome d'hydrogène, un groupe hydrocarboné aliphatique comportant 1 à 4 atomes de carbone, un groupe hydrocarboné aromatique, un atome de brome ou un atome de chlore et n et m représentent des nombres entiers de 1 à 4.

5. Composition de résine phénolique selon la revendication 3, dans laquelle la résine phénolique (I) est obtenue par la réaction en outre avec un autre composé de triazine contenant un groupe amino (x4), hormis pour le composé de triazine (x2), en plus des phénols (x1), du composé (x2) et des aldéhydes (x3).

6. Composition de résine phénolique selon la revendication 5, dans laquelle le composé de triazine contenant un groupe amino (x4) est au moins un composé choisi dans le groupe constitué de la mélamine, de l'acétoguanamine et de la benzoguanamine.

7. Composition de résine phénolique selon la revendication 1, dans laquelle une viscosité en fusion ICI de la résine phénolique (I) à 150°C est de 100 poises ou moins.

8. Composition de résine phénolique selon la revendication 1, dans laquelle la résine phénolique (I) contient un atome d'azote en une proportion de 2 à 13 % en masse dans la structure moléculaire.

9. Composition de résine phénolique selon la revendication 8, dans laquelle la résine phénolique (I) contient un groupe carboxyle contenu dans la résine en un équivalent groupe carboxyle dans la plage de 500 à 1 500 g/équivalent.

10. Composition de résine phénolique selon la revendication 1, dans laquelle l'agent durcisseur (II) est une résine époxy.

11. Composition de résine phénolique selon la revendication 10, dans laquelle un rapport de composition de la résine phénolique (I) à la résine époxy correspond à un rapport molaire du groupe hydroxyle phénolique dans la résine phénolique (I) au groupe époxy contenu dans la résine époxy (groupe hydroxyle phénolique/groupe époxy), dans laquelle le rapport molaire est dans la plage de 0,8 à 1,2.

12. Article durci qui est obtenu par thermodurcissement de la composition de résine phénolique selon l'une quelconque des revendications 1 à 11.

13. Composition de résine pour un stratifié plaqué de cuivre, comprenant la composition de résine phénolique selon l'une quelconque des revendications 1 à 11 et un solvant organique.

14. Stratifié plaqué de cuivre qui est obtenu par un procédé comprenant les étapes d'imprégnation d'un tissu de verre avec une composition de résine selon la revendication 13 pour obtenir un pré-imprégné, de stratification d'une pluralité de pré-imprégnés et de feuilles de cuivre, et de durcissement.

15. Résine phénolique qui a une structure moléculaire obtenue par la réaction de phénols (x1), d'un composé de triazine (x2) comprenant un groupe hydrocarboné aromatique contenant un groupe carboxyle et un groupe amino en tant que substituants sur le noyau triazine, et d'aldéhydes (x3), et qui a aussi un site structurel représenté par la formule structurelle (1) présentée ci-dessous : 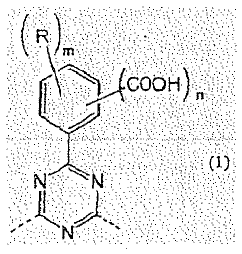 dans laquelle R représente un atome d'hydrogène, un groupe hydrocarboné aliphatique comportant 1 à 4 atomes de carbone, un groupe hydrocarboné aromatique, un atome de brome ou un atome de chlore, la partie de ligne en pointillés représente une liaison avec une autre structure moléculaire et n et m représentent des nombres entiers de 1 à 4, dans la structure moléculaire, dans laquelle la viscosité en fusion ICI de la résine phénolique à 150°C est de 10 pa.s (100 poises) ou moins.

16. Résine phénolique selon la revendication 15, dans laquelle la résine phénolique est obtenue par la réaction en outre avec un autre composé de triazine contenant un groupe amino (x4), hormis pour le composé de triazine (x2), en plus des phénols (x1), du composé (x2) et des aldéhydes (x3).

17. Composition de résine phénolique selon la revendication 15 ou 16, dans laquelle la résine phénolique contient un atome d'azote en une proportion de 2 à 13 % en masse dans la structure moléculaire.

18. Composition de résine phénolique selon la revendication 15 ou 16, dans laquelle la résine phénolique contient un groupe carboxyle contenu dans la résine en un équivalent groupe carboxyle dans la plage de 500 à 1 500 g/équivalent.
